**Europäisches Patentamt**

**European Patent Office**

**Office européen des brevets**

(11) Numéro de publication : **0 430 823 B1**

(12) **FASCICULE DE BREVET EUROPEEN**

(45) Date de publication du fascicule du brevet :
**08.06.94 Bulletin 94/23**

(21) Numéro de dépôt : **90420481.5**

(22) Date de dépôt : **07.11.90**

(51) Int. Cl.⁵ : **G01R 27/16,** G01R 27/20

(54) **Système de contrôle permanent de la conduction électrique d'un réseau.**

(30) Priorité : **24.11.89 FR 8915689**

(43) Date de publication de la demande :
**05.06.91 Bulletin 91/23**

(45) Mention de la délivrance du brevet :
**08.06.94 Bulletin 94/23**

(84) Etats contractants désignés :
**BE CH DE ES FR GB IT LI SE**

(56) Documents cités :
**DE-B- 1 137 509**

(73) Titulaire : **MERLIN GERIN**
**2, chemin des Sources**
**F-38240 Meylan (FR)**

(72) Inventeur : **Suptitz, Eric**
**Merlin Gerin,**
**Sce. Brevets**
**F-38050 Grenoble Cédex (FR)**
Inventeur : **Diaferia, Joseph**
**Merlin Gerin,**
**Sce. Brevets**
**F-38050 Grenoble Cédex (FR)**

(74) Mandataire : **Jouvray, Marie-Andrée et al**
**MERLIN GERIN**
**Sce. Propriété Industrielle**
**F-38050 Grenoble Cédex 9 (FR)**

**EP 0 430 823 B1**

Jouve, 18, rue Saint-Denis, 75001 PARIS

## Description

SYSTEME DE CONTROLE PERMANENT DE LA CONDUCTION ELECTRIQUE D'UN RESEAU

L'invention concerne un système de contrôle permanent de la conduction électrique d'un réseau comportant des premier et second conducteurs alimentés par une source de tension alternative.

Dans un réseau électrique, les problèmes de mauvaise conduction sont liés soit à la défaillance des connexions, par exemple les connexions des barres d'un tableau basse tension, soit à la défaillance des contacts d'appareillage insérés dans le réseau, par exemple les contacts de disjoncteurs. Le desserrage d'une connexion entraîne un échauffement local qui peut être responsable de la détérioration du matériel voisin et peut provoquer des incendies.

Il a été proposé de surveiller certains contacts par des moyens permettant de détecter un échauffement local. Selon un premier procédé de surveillance, la température du contact est mesurée, une thermistance ou un thermocouple étant associé à chaque contact à surveiller. Un tel procédé nécessite un grand nombre de capteurs de température, un par contact à surveiller, chacun des capteurs devant en outre être connecté à un dispositif de traitement de l'information, ce qui implique un grand nombre de fils. Selon un second procédé, une caméra est utilisée pour réaliser des photos thermographiques pour détecter les points chauds sur un jeu de barres. Il n'est bien entendu pas question de disposer une caméra en face de chaque point à surveiller et un tel procédé ne peut être utilisé pour une surveillance permanente, mais uniquement dans le cadre d'une maintenance occasionnelle.

L'invention a pour but un système, à la fois simple et fiable, permettant d'exercer en permanence une surveillance de la conduction d'un réseau.

Le brevet allemand DE-B-1.137.509 divulgue un dispositif de mesure de la résistance ohmique interne d'un réseau, destiné à permettre la détection de court-circuits. La mesure s'effectue lorsque le réseau est sous-tension par interposition en des points de mesure du réseau d'un circuit série constitué par une résistance et un redresseur. La composante continue de la tension aux bornes des points de mesure est mesurée au moyen d'un filtre et affichée, cette composante étant représentative de la résistance ohmique interne du réseau.

Une technique comparable est utilisée, selon l'invention, pour contrôler la conduction électrique d'un réseau.

Le système de mesure selon l'invention comporte au moins un module de mesure comportant des moyens de production d'une composante continue de courant entre des premier et second points situés respectivement sur les premier et second conducteurs, des moyens de mesure de la tension appliquée entre ces premier et second points, et des moyens d'extraction de la composante continue de ladite tension. Il est caractérisé en ce qu'il est destiné à assurer un contrôle permanent de la conduction électrique d'au moins une portion du réseau, la sortie des moyens d'extraction étant connectée à l'entrée d'un circuit de traitement et de signalisation comportant des moyens de calcul d'une valeur représentative de la résistance de ligne d'une portion du réseau, des moyens de détection d'une variation de ladite valeur, des moyens de comparaison de ladite variation à un seuil prédéterminée et des moyens de signalisation d'un défaut de conduction lorsque ladite variation dépasse ledit seuil.

Selon un perfectionnement de l'invention, l'influence éventuelle de charges connectées sur le réseau en aval du module de mesure est éliminée par le fait que les moyens de production de la composante continue de courant sont destinés à être connectés entre ledit second point et un troisième point du premier conducteur adjacent au premier point de manière à délimiter entre les premier et troisième points une résistance de shunt contituée par une portion sans contact du premier conducteur, le module de mesure comportant des moyens de mesure de la tension aux bornes de la résistance de shunt et des moyens d'extraction de la composante continue de la tension aux bornes de la résistance de shunt, la valeur représentative de la résistance de ligne calculée par le circuit de traitement étant proportionnelle au rapport des composantes continues des tensions mesurées respectivement entre lesdits premier et second points et aux bornes de la résistance de shunt.

Selon un autre perfectionnement de l'invention, le système comporte au moins un module de rebouclage comportant des bornes d'entrée destinées à être connectées à des quatrième et cinquième points situés respectivement sur les premier et second conducteurs du réseau, ledit module de rebouclage comportant des moyens de bouclage de ladite composante continue de courant. Le module de rebouclage peut être constitué par un module d'asservissement comportant des moyens d'asservissement à zéro de la composante continue de la tension appliquée entre ses bornes d'entrée, la résistance de ligne calculée par le circuit de traitement du module de mesure étant la résistance de ligne de la portion du réseau comprise entre les modules de mesure et d'asservissement.

En disposant alternativement des modules de mesure et d'asservissement le long d'un réseau, il est possible de surveiller la conduction de toutes les portions du réseau comprises entre ces modules, sans perturber le fonctionnement du réseau, et de détecter dans quelle portion du réseau le défaut de conduction s'est produit.

Un tel système est utilisable sans problème même sur des réseaux déjà existants. Il suffit en effet de connecter les modules du système aux conducteurs du réseau. Il est à noter que l'absence de connexion additionnelle entre les différents modules facilite énormément la mise en place d'un tel système.

Selon un développement de l'invention, les moyens de production d'une composante continue du courant d'un module de mesure comportent un redresseur contrôlé, dont la commande est connectée à la sortie d'un régulateur, et le système comporte une unité centrale de traitement connectée à chaque module de mesure de manière à commander la mise en service du redresseur contrôlé du module de mesure.

Il est alors possible de surveiller un réseau comportant une pluralité de branches au moyen d'un système comportant un module d'asservissement disposé en amont de la portion du réseau à surveiller et un module de mesure connecté en aval de chacune des branches terminales du réseau à surveiller, l'unité centrale de traitement commandant la mise en service séquentielle des redresseurs contrôlés des modules de mesure et recevant en permanence des différents modules de mesure une valeur représentative de la composante continue de la tension aux bornes dudit module de mesure, l'unité centrale de traitement comportant des moyens de calcul des valeurs représentatives de la résistance de ligne des diverses portions du réseau, des moyens de détection d'une variation desdites valeurs, des moyens de comparaison desdites variations à des seuils respectifs prédéterminés, et des moyens de signalisation d'un défaut de conduction dans l'une desdites portions lorsque la variation de la valeur associée à ladite portion dépasse le seuil correspondant.

D'autres avantages et caractéristiques ressortiront plus clairement de l'exposé qui va suivre de modes particuliers de réalisation de l'invention, donnés à titre d'exemples non limitatifs et représentés aux dessins annexés sur lequels:

La figure 1 illustre schématiquement le principe de mesure à la base du système de mesure selon l'invention.

La figure 2 représente un mode particulier de réalisation d'un filtre d'un système selon l'invention.

La figure 3 représente schématiquement un perfectionnement au principe illustré sur la figure 1.

La figure 4 représente un circuit selon la figure 3 dans lequel une charge est connectée en amont du module de mesure.

La figure 5 représente schématiquement un perfectionnement au principe illustré sur la figure 3.

La figure 6 représente schématiquement un mode de réalisation d'un module de mesure destiné à la mise en oeuvre des principes illustrés aux figures 3 et 5.

La figure 7 représente l'organigramme de fonctionnement d'un circuit du traitement d'un module de mesure selon la figure 6.

La figure 8 illustre la courbe de desserrement d'un contact.

La figure 9 représente, sous forme de schéma-bloc, un mode de réalisation d'un module d'asservissement.

La figure 10 représente une variante de l'étage de puissance d'un module.

La figure 11 illustre les formes d'onde des signaux en certains points de l'étage de puissance selon la figure 10.

La figure 12 illustre une variante d'un filtre.

La figure 13 représente un module de mesure double.

Les figures 14 et 15 représentent respectivement l'application de l'invention à une ligne et à la structure arborescente d'un réseau dans un tableau basse tension.

La figure 16 est un schéma simplifié de la figure 15.

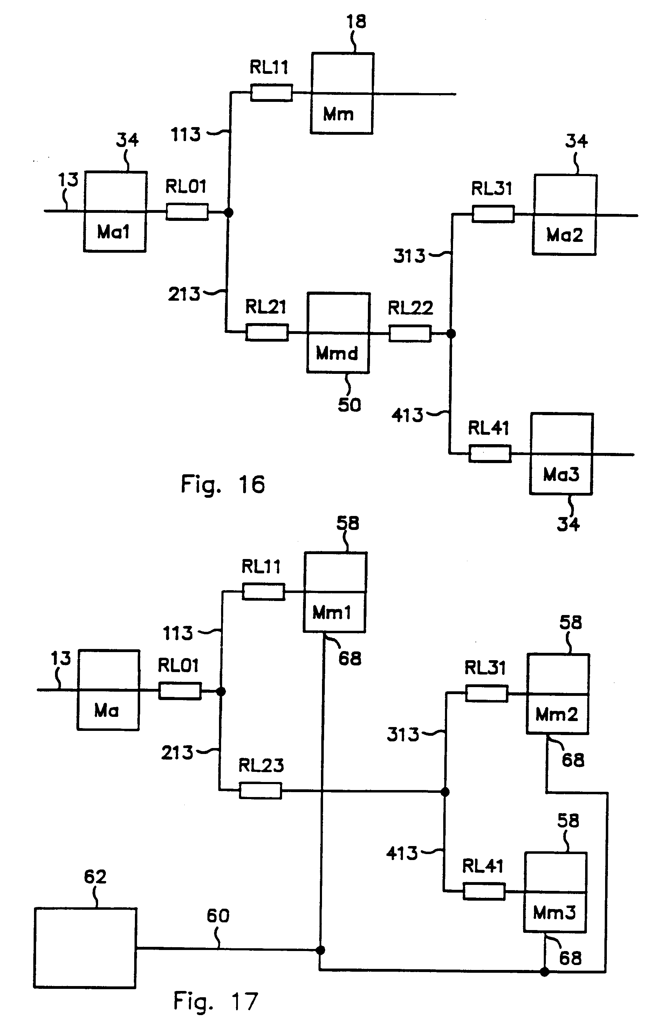

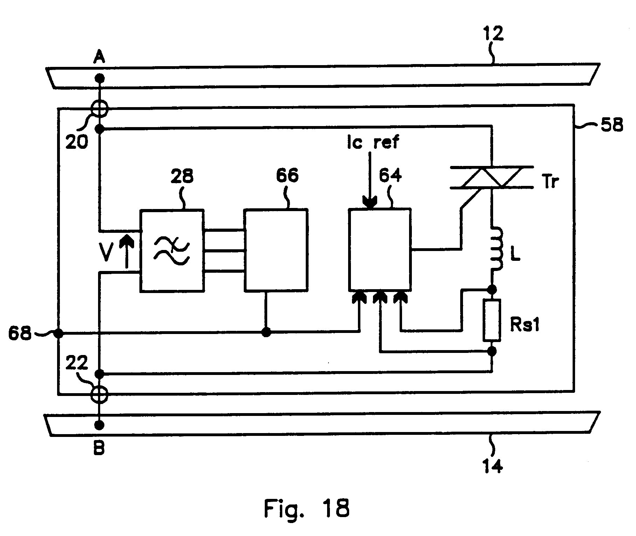

Une autre variante de l'invention est illustrée aux figures 17 et 18.

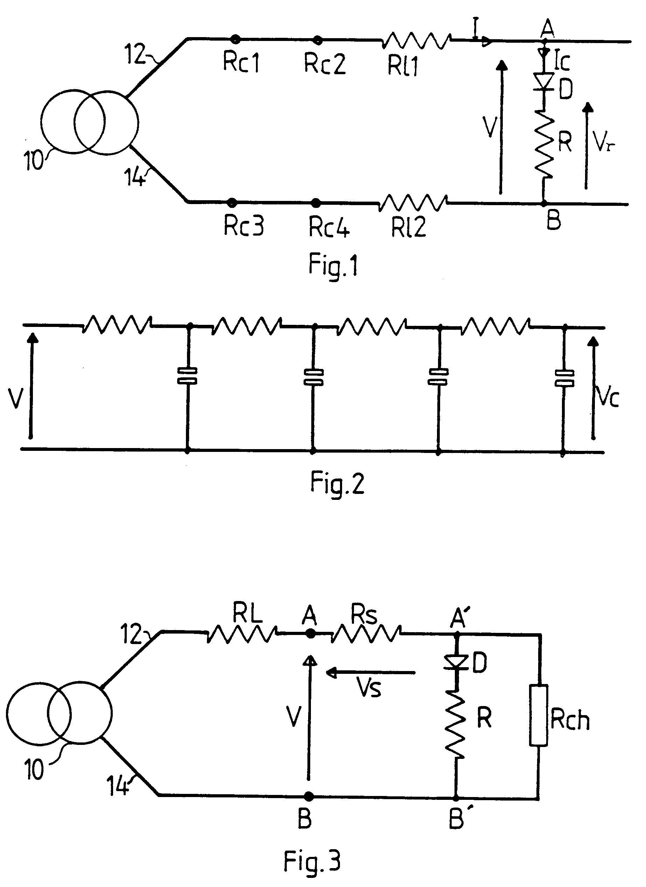

Sur la figure 1 un réseau électrique, monophasé, relié à la sortie d'un transformateur basse tension 10, est alimenté en tension alternative par le transformateur. Des résistances Rl1 et Rl2 schématisent la résistance de ligne de chacun des fils conducteurs 12 et 14 du réseau, en amont de points A et B situés respectivement sur chacun des fils. Des résistances Rc1 à Rc4 schématisent des résistances de contact dues à l'interposition de contacts ou de connexions sur le réseau, entre le transformateur et les points A et B. Un courant alternatif la parcourt le réseau.

La résistance de ligne RL du réseau en amont des points A et B, constituée par la somme des résistances de ligne Rl1 et Rl2 de chacun des fils et des résistances de contact Rc1 à Rc4, est représentative de la conduction du réseau en amont des points A et B.

Une perturbation dans la conduction du réseau, due par exemple au desserrement d'un contact, se traduit en effet par une augmentation de la résistance de ligne RL. Si la résistance de ligne RL est mesurée en permanence, toute augmentation peut être détectée et signalée dès qu'elle dépasse un seuil prédéterminé considéré comme significatif. Selon un mode de réalisation préférentiel, toute variation de la résistance de ligne RL supérieure à 0,1 milliohms est considérée comme anormale et signalée à l'utilisateur.

Afin que la mesure de la résistance de ligne RL ne soit pas perturbée par des phénomènes inductifs, une composante de courant continu Ic, par exemple de l'ordre de 100 mA, est superposée au courant alternatif Ia pendant la mesure. Le système selon l'invention comporte un module de mesure comportant des moyens de production d'une composante continue de courant. Sur la figure 1, ces moyens sont schématisés par la connexion entre des bornes situées aux points A et B d'une diode D en série avec une résistance de dissipation R. Ic étant le courant continu parcourant la diode D et la résistance R, la portion du réseau située en amont des points A et B est parcourue par un courant I = Ia + Ic et la tension V entre les bornes A et B est constituée par la superposition d'une composante alternative v et d'une composante continue Vc = RL. Ic. La résistance de ligne RL peut ainsi être obtenue en faisant le rapport Vc/Ic entre la valeur de la composante continue Vc de la tension V aux bornes A et B et la valeur de la composante continue Ic du courant.

La résistance R étant connue, la tension Vr = R.Ic à ses bornes est représentative de la composante continue Ic du courant. La mesure des tensions V et Vr, puis l'extraction de leurs composantes continues, permet d'obtenir des valeurs représentatives de Vc et Ic et de calculer la résistance de ligne RL.

Pour extraire la composante continue Vc de la tension V le module de mesure comporte un filtre à l'entrée duquel est appliqué le signal de tension V et fournissant en sortie le signal Vc. Un tel filtre, de type passebas, est, dans un mode de réalisation préférentiel, continué par un filtre du type RC du 4ème ordre tel que représenté à la figure 2. A titre d'exemple, le réseau étant alimenté en tension alternative à 50 Hz, les valeurs des éléments constitutifs du filtre sont choisis de manière à définir une fréquence de coupure de 0,5 Hz et une atténuation voisine de 160 dB à 50 Hz.

Une mesure réalisée conformément au principe illustré sur la figure 1 peut être perturbée lorsqu'une charge est connectée au réseau en aval des points A et B. En effet, la résistance mesurée est alors constituée par la résistance de ligne RL en parallèle sur la résistance de charge. Cette perturbation peut être négligée lorsque la résistance de la charge est très supérieure à la résistance de ligne RL. La mesure peut également être perturbée si une charge asymétrique, créant une composante continue additionnelle est connectée en aval des points A et B, la composante continue du courant mesurée ne correspondant pas, dans ce cas, à la composante continue du courant dans la résistance de ligne RL.

La figure 3 illustre un perfectionnement au principe de mesure selon la figure 1, permettant, sans déconnecter la charge pendant la mesure, de s'affranchir des contraintes liées à la présence éventuelle, en aval des points A et B, d'une charge relativement faible, par exemple constituée par l'enroulement primaire d'un transformateur, ou d'une charge asymétrique, par exemple un redresseur mono-alternance, introduisant une composante continue additionnelle.

Selon la figure 3, la mesure du courant est réalisée sur un shunt Rs, matérialisé par une portion ne comportant pas de contact de la ligne à surveiller. Le shunt Rs schématisé sur la figure est constitué par la portion de ligne comprise entre le point A du conducteur 12 et un point A' situé en aval du précédent, la diode D et la résistance R étant connectées en série entre une borne située au point A' et une borne située en un point B' du conducteur 14, les points B et B' étant de préférence confondus. La résistance Rs du shunt étant connue, la composante continue de la tension Vs mesurée entre les bornes A et A' fournit une valeur représentative de la composante continue du courant parcourant la résistance de ligne RL et, en combinaison avec la composante continue de la tension V mesurée entre les bornes A et B, permet d'obtenir une valeur de la résistance de ligne RL indépendante de la charge. Le rapport des composants continues de V et Vs est égal au rapport des résistances de ligne RL et de shunt Rs. Une augmentation de ce rapport est interprétée comme une augmentation de la résistance de ligne.

A titre d'exemple, si la mesure est effectuée dans un tableau basse tension dans lequel le réseau est constitué par des barres conductrices en cuivre, le shunt Rs est constitué par une portion de barre comprise entre les bornes A et A'. Pour une portion de barre de cuivre de 50 mm de large et de 5 mm d'épaisseur, destinée au passage d'un courant nominal de 630 A, et de 10 cm de long, la résistance Rs est de l'ordre de 8 microohms. De même, si la mesure est réalisée dans une zone où le réseau est constitué par des câbles, le shunt est constitué par une portion de câble. Pour un câble de 6 mm$^2$, la résistance Rs d'une portion de câble de 10 cm de long est de l'ordre de 300 microohms.

Le même courant parcourant la résistance de ligne et le shunt Rs, toute variation de la résistance de ligne due à une augmentation de la température est compensée par une variation équivalente de la résistance de shunt. Le rapport des composantes continues de V et Vs, égal au rapport RL/Rs des résistances de ligne et de shunt, reste constant quelle que soit la température s'il n'y a pas desserrement d'un contact. Ainsi, l'échauffement normal d'une barre, qui conduit à une augmentation simultanée de la résistance de ligne et de la résistance de shunt, n'est pas interprété comme un desserrement d'un contact, seul le rapport entre les deux résistances étant pris en compte.

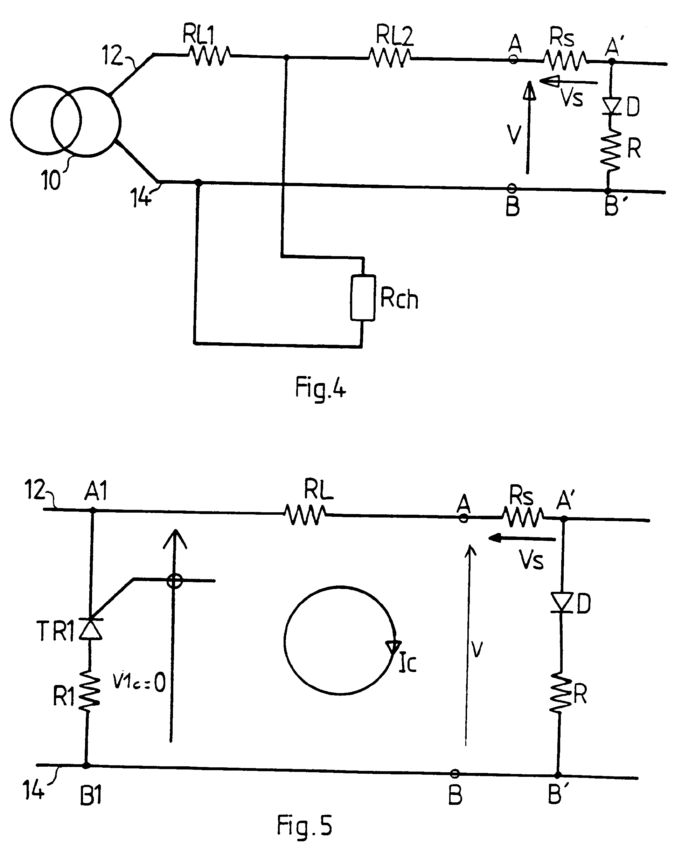

Lorsque comme illustré sur la figure 4, une charge Rch est connectée en amont des points A et B, la résistance de ligne RL peut être divisée en deux résistances de ligne partielles : RL1 entre le transformateur

4

10 et les points de connexion de la charge Rch au réseau (12,14) et RL2 entre ces points de connexion et les points A et B. La résistance effectivement mesurée correspond alors à RL2 + RL1•Rch/ (RL1 + Rch) et non à RL = RL1 + RL2.

Un perfectionnement de l'invention permet de s'affranchir de l'influence éventuelle de charges connectées en amont des points A et B. Selon ce perfectionnement, la résistance de ligne RL mesurée est la résistance d'une portion de ligne comprise entre les points A et B et des points A1 sur le conducteur 12, et B1 sur le conducteur 14 entre lesquels sont connectés des moyens permettant de reboucler la composante de courant continu Ic.

Ces moyens de rebouclage peuvent être constitués par une seconde diode connectée en série avec une résistance de même valeur que R entre les points A1 et B1, la seconde diode étant polarisée en inverse par rapport à la diode D.

Selon un mode de réalisation préférentiel illustré sur la figure 5, les moyens de rebouclage sont constitués par une résistance de dissipation R1 en série avec un thyristor Th1 connecté de manière à permettre le passage du courant du conducteur 14 au conducteur 12, soit en sens inverse de la diode D. Le thyristor Th1 est commandé de manière à annuler la composante continue V1c de la tension V1 aux bornes des points A1 et B1. De cette manière, le rapport Vc/Ic fournit effectivement la résistance de ligne de la portion de ligne comprise entre les points A et B et les points A1 et B1, sans être affecté par les charges éventuellement connectées en aval ou amont de cette portion de ligne.

Si l'on désire uniquement s'affranchir des charges éventuellement connectées en amont, les charges connectées en aval étant suffisamment élevées pour être négligées, le même procédé de rebouclage du courant continu peut également être appliqué à un système utilisant le principe de mesure selon la figure 1. On mesure alors la résistance de ligne d'une portion de réseau comprise entre les points A et B et des points A1 et B1, par exemple en asservissant la composante continue V1c à zéro et en mesurant les composantes continues des tensions V et Vr. Lorsqu'une mesure précise n'est pas nécessaire on peut, en première approximation, considérer que le courant continu Ic est constant (par exemple 100 milliampères) et que la composante continue Vc est représentative de la résistance de ligne. Toute variation de la résistance de ligne se traduit par une variation proportionnelle de la composante continue Vc. Seules les variations de cette composante sont surveillées et toutes variation supérieure à un seuil prédéterminé, par exemple 10 microvolts, est signalé. Le module de mesure est alors très simple.

Un système de mesure utilisant le principe illustré sur la figure 5 comporte au moins un module de mesure, connecté aux points A, A', B et éventuellement B' du réseau, et un module d'asservissement connecté aux point A1 et B1.

Le réseau est donc segmenté en portions (A-A1, B-B1) de ligne dont les extrêmités sont connectées respectivement à un module de mesure et à un module d'asservissement, de manière à contrôler la résistance de ligne de cette portion de ligne. La segmentation du réseau permet de contrôler la conduction sur tout le réseau et de localiser facilement un défaut de conduction. Pour conserver une bonne sensibilité au système il est souhaitable de limiter la portion de ligne contrôlée située entre les modules de mesure et d'asservissement. En effet la résistance de ligne RL mesurée est constituée par la somme des résistances de ligne des barres ou câbles et des résistances de contact des connexions interposées sur la portion de ligne à contrôler. Pour détecter le desserrement d'un contact, c'est-à-dire une augmentation de la résistance de contact il faut que le rapport entre la résistance de ligne des barres, ou câbles, et la résistance de contact soit raisonnable. A titre d'exemple si la portion de ligne à surveiller est constituée par une barre de 50X5, ayant une résistance de 0,075 milliohms/m, et que le système doit détecter une résistance de contact de 0,1 milliohms constituant 5 % de la résistance de barre, la longueur de barre pouvant être surveillée est de 27 mètres.

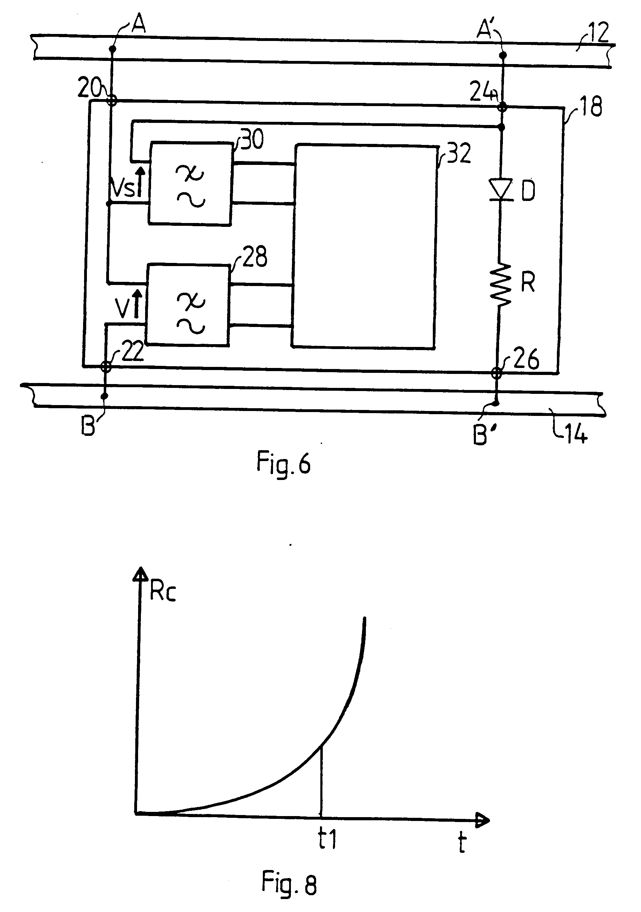

Le module de mesure 18 selon la figure 6 comporte des bornes 20,22,24 et 26 destinées à être reliées respectivement à des points A, B, A' et B' du réseau. La distance séparant les points A et A' est déterminée en fonction du type de réseau, par exemple 10 cm dans le cas d'une barre de 50X5. Les bornes 24 et 26 sont connectées par la diode D en série avec la résistance R. Les bornes 20 et 22 sont connectées aux entrées d'un premier filtre passe-bas 28, par exemple du type représenté à la figure 2. Les bornes 20 et 24 sont connectées aux entrées d'un second filtre passe-bas 30, de même type que le précédent. Les signaux de sortie des filtres 28 et 30, représentant respectivement les composantes continues des tensions V et Vs, sont appliquées aux entrées d'un circuit électronique de traitement et de signalisation 32.

Le circuit 32 calcule la valeur de la résistance de ligne de la portion du réseau à surveiller, la résistance de ligne étant égale au produit de la résistance de shunt Rs par le rapport des composantes continues Vc et (Vs)c des tensions V et Vs. La valeur de Rs peut être prédéterminée, des tables indiquant les valeurs correspondantes de la distance AA' à respecter en fonction du type de conducteur formant la ligne 12. Selon une variante, le circuit 32 peut contenir des moyens d'entrée de la valeur Rs, par exemple un potentiomètre ou un commutateur.

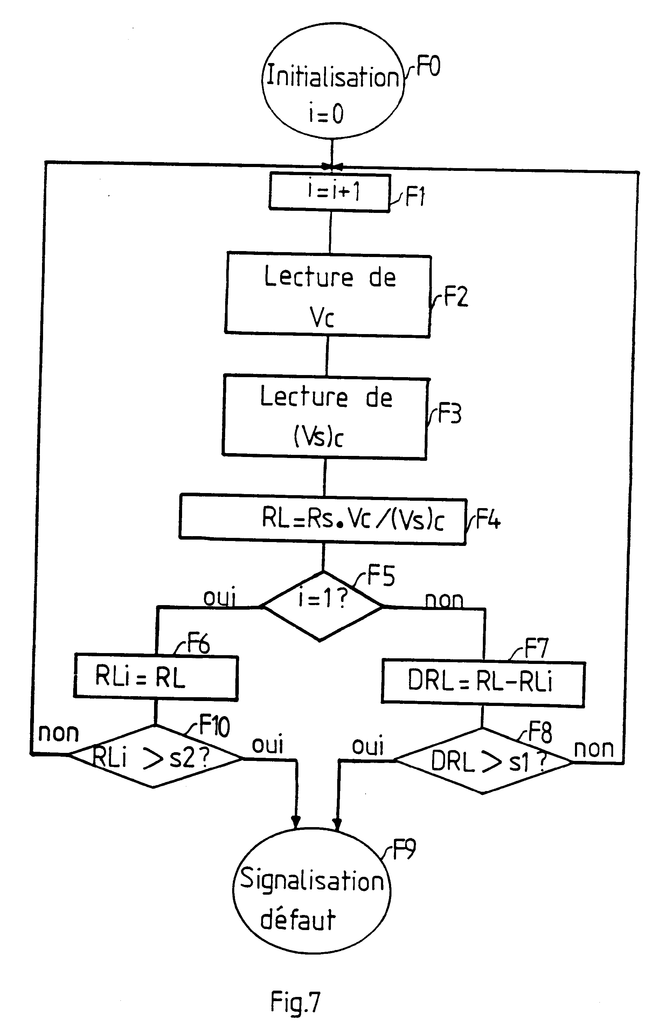

Le circuit 32 surveille les variations de la résistance de ligne. Selon un mode particulier de réalisation illustré à la figure 7, le circuit 32 comporte un microprocesseur connecté à au moins une mémoire vive. Lorsque le module est connecté au réseau à surveiller, le microprocesseur, après une phase d'initialisation (FO), pendant laquelle le contenu i d'un registre est mis à O, incrémente (F1) la valeur i, puis lit (F2, F3) les valeurs Vc et (Vs)c et calcule (F4) la résistance de ligne RL. Lorsqu'il s'agit de la première valeur calculée (F5 : i = 1), cette valeur initiale RL i est mise en mémoire (F6). Sinon, le microprocesseur calcule (F7) la différence DRL entre la dernière résistance de ligne calculée RL et la résistance de ligne initiale RLi. Cette différence est comparée (F8) à un seuil prédéterminé s1, par exemple 0, 1 milliohms, et lorsque la différence est supérieure à ce seuil, le microprocesseur envoie un ordre de signalisation d'un défaut (F9). Si la différence DRL est inférieure à ce seuil S1, un nouveau cycle de mesure commence. Le module surveille ainsi en permanence la résistance de ligne et signale toute augmentation de cette résistance supérieure à un seuil prédéterminé s1.

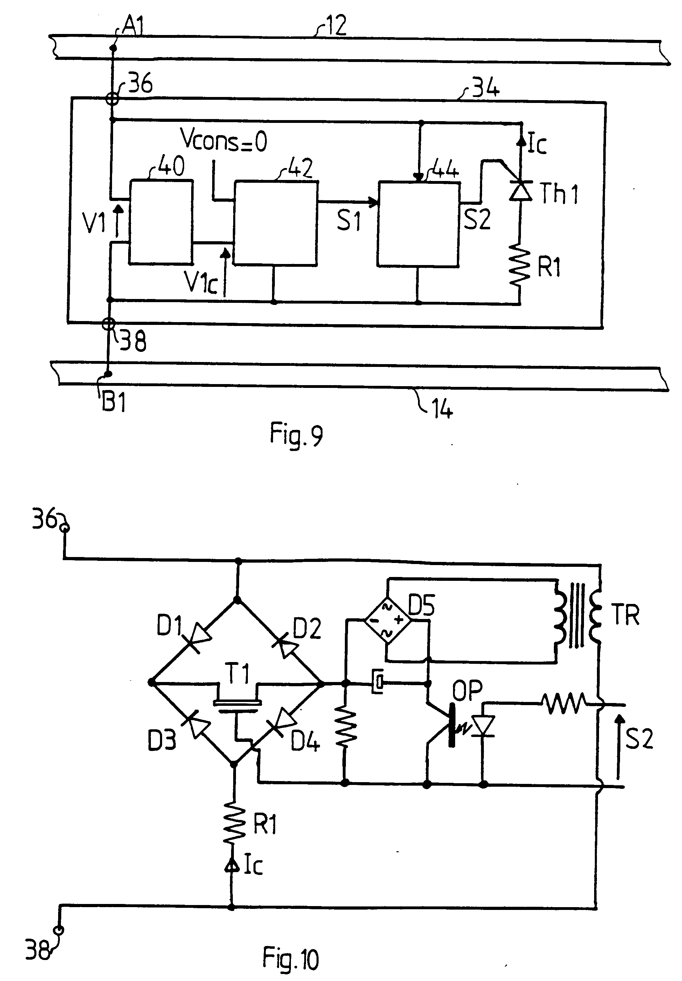

En ne surveillant que l'augmentation de la résistance de ligne il est possible de surveiller des portions de ligne de diverses dimensions. Dans la description ci-dessus la portion de réseau à surveiller est supposée ne pas comporter de contacts desserres lors de la connexion du dispositif de mesure au réseau. En pratique, ce procédé est applicable également lorsqu'un contact est partiellement desserré lors de la connexion. En effet, la courbe de desserrement varie de façon sensiblement exponentielle avec le temps, la résistance de contact Rc d'un contact desserré augmentant d'abord lentement, puis très rapidement comme représenté sur la figure 8. A titre d'exemple, si la connexion est réalisée en temps t1, l'augmentation de la résistance de contact est telle qu'elle peut être détectée en quelques cycles de mesure du microprocesseur.

La valeur initiale RLi peut éventuellement (F10) être comparée à un seuil s2 avant que le microprocesseur ne commence un second cycle de mesure, le seuil s2 étant suffisamment élevé pour être représentatif d'un mauvais contact pour toutes les résistances de ligne susceptibles d'être mesurées par le dispositif. Si la valeur RLi est supérieure au seuil s2, le microprocesseur envoie un ordre de signalisation de défaut (F9), sinon un nouveau cycle de mesure est réalisé.

Le module d'asservissement 34 selon la figure 9 comporte deux bornes d'entrée 36 et 38, destinées à être reliées respectivement à des points A1 et B1 délimitant une extrémité de la portion de ligne (12,14) à surveiller.

Les bornes 36 et 38 du module d'asservissement 34 sont connectées aux entrées d'un filtre passe-bas 40, qui peut être du type représenté à la figure 2. Le signal de sortie du filtre 40 est représentatif de la composante continue V1c de la tension V1 entre les points A1 et B1. La composante continue V1c est asservie à zéro dans le module d'asservissement 34. La composante continue V1c et une tension de consigne nulle, Vcons, sont appliquées à l'entrée d'un régulateur 42, qui peut être un régulateur classique de type PID (Proportionnel-intégrateur-dérivateur). Le signal de tension S1 de sortie du régulateur 42 est appliqué à l'entrée d'un circuit de commande 44 dont les signaux S2 de sortie sont appliqués sur l'entrée de commande d'un étage de puissance constitué par le circuit (R1,Th1) destiné à reboucler la composante de courant continu Ic. Sur la figure 9, les signaux S2 sont appliqués à la gâchette du thyristor Th1, le circuit de commande 44 produisant des impulsions S2, synchronisées sur la fréquence de la tension alternative appliquée au réseau 12,14 à surveiller et dont la durée, déterminant l'angle de retard à l'allumage du thyristor, est une fonction prédéterminée de la tension S1 de sortie du régulateur 42. Pour permettre une synchronisation des impulsions S2 sur la fréquence du réseau, une entrée du circuit de commande est connectée à la borne 36.

La figure 10 représente une variante de l'étage de puissance du module d'asservissement 34. Un pont de diodes, D1 à D4, est connecté en série avec la résistance R1 entre les bornes 36 et 38 du module. Un transistor T1, de type MOSFET, est connecté entre les bornes de sortie continu du pont de diodes. La sortie S2 du circuit de commande est appliquée à la base du transistor T1 par l'intermédiaire d'un optocoupleur OP. Un transformateur TR, dont l'enroulement primaire est connecté aux bornes 36 et 38 et dont l'enroulement secondaire est connecté à un pont de diodes D5, alimente la partie réceptrice de l'optocoupleur OP.

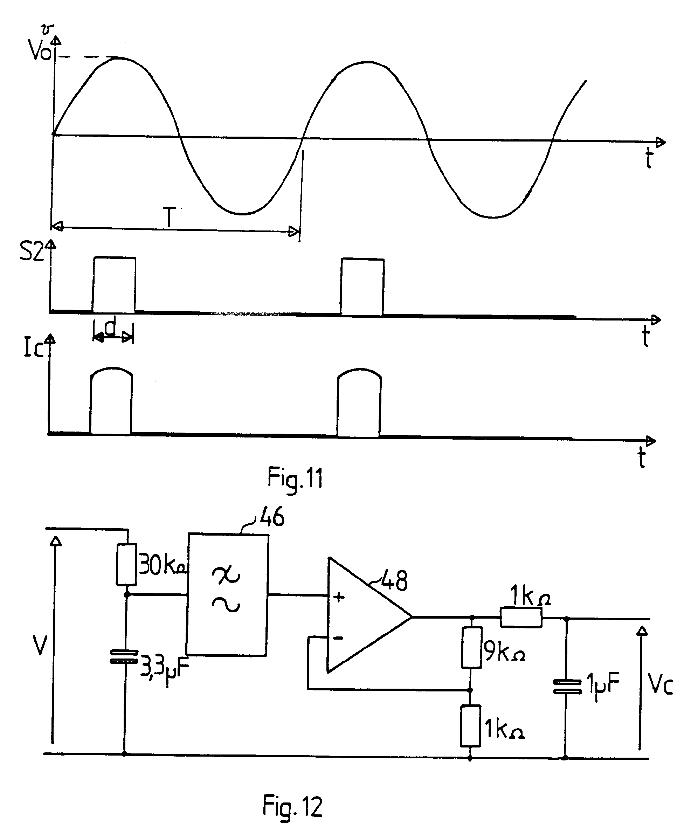

Avec des impulsions S2, de durée d, représentées à la figure 11, le courant Ic dans le transistor T1 et la résistance R1 est de la forme représentée sur la figure 11 et la valeur moyenne du courant est donnée par :

$Ic = Vo/\pi R1 \bullet \sin \pi.d/T$, où T et Vo sont respectivement la période et la tension crête de la tension alternative v appliquée au réseau à surveiller, et où d est la durée d'une impulsion S2. Si le circuit de commande 44 est conçu de manière à ce que la fonction prédéterminée reliant la durée d d'une impulsion S2 à la tension S1 de sortie du régulateur soit une fonction de type Arc sin (S1), la valeur moyenne du courant Ic est proportionnelle à S1.

D'autres modes de réalisation de l'étage de puissance peuvent être envisagés. En particulier, pour éliminer la résistance de dissipation R1, on peut envisager d'utiliser un circuit non dissipatif (LC) accordé sur la fréquence du réseau.

Selon une autre variante de réalisation, l'étage de puissance est constitué par une inductance disposée en série avec un triac entre les bornes A1 et B1, constituant ainsi un circuit non dissipatif. Le triac est, comme le thyristor Th1 selon la figure 9, commandé par les signaux S2 de sortie du circuit de commande 44. Dans une telle variante, l'inductance peut être faible, par exemple de l'ordre du millihenry pour un courant moyen de l'ordre de 1A à travers le triac.

Afin d'assurer une régulation optimale indépendamment des variations de l'impédance du réseau, le régulateur 42 peut être un régulateur de type adaptatif.

Selon un mode particulier de réalisation, les filtres passe-bas 28,30 et 40 sont du type représenté à la figure 12, comportant un filtre 46 à capacités commutées du 10ème ordre, de type BUTTERWORTH, ayant une fréquence de coupure de 15 Hz, et les tensions à l'entrée et à la sortie du filtre 46 sont respectivement de l'ordre de 3,5 V et 20 microvolts, pour une tension alternative d'entrée ayant une tension crête de 220 V et de fréquence 50 Hz. Pour permettre un traitement ultérieur correct de la composante continue, la sortie du filtre 46 est connectée à l'entrée d'un amplificateur 48, de gain 10, ayant une tension d'offset inférieure à 5 microvolts.

Afin de standardiser les modules de mesure et d'asservissement, les moyens (D,R) de production d'une composante continue du courant dans un module de mesure peuvent être remplacés par un étage de puissance du même type que celui du module d'asservissement (figures 9 et 10) commandé à partir de la composante continue Vc par une boucle d'asservissement du même type que celle décrite en regard de la figure 9, dans laquelle la valeur de consigne Vcons est différente de zéro. Dans le cas où le circuit de puissance est constitué par un triac en série avec une inductance, le module de mesure ne diffère alors d'un module d'asservissement que par le fait que la valeur de consigne n'est pas nulle et qu'il comporte de plus un filtre 30, destiné à être connecté aux points A et A', et un circuit électronique de traitement 32. Bien entendu si l'on utilise un thyristor, celui-ci est connecté dans des sens opposés selon qu'il s'agit d'un module de mesure ou d'un module d'asservissement.

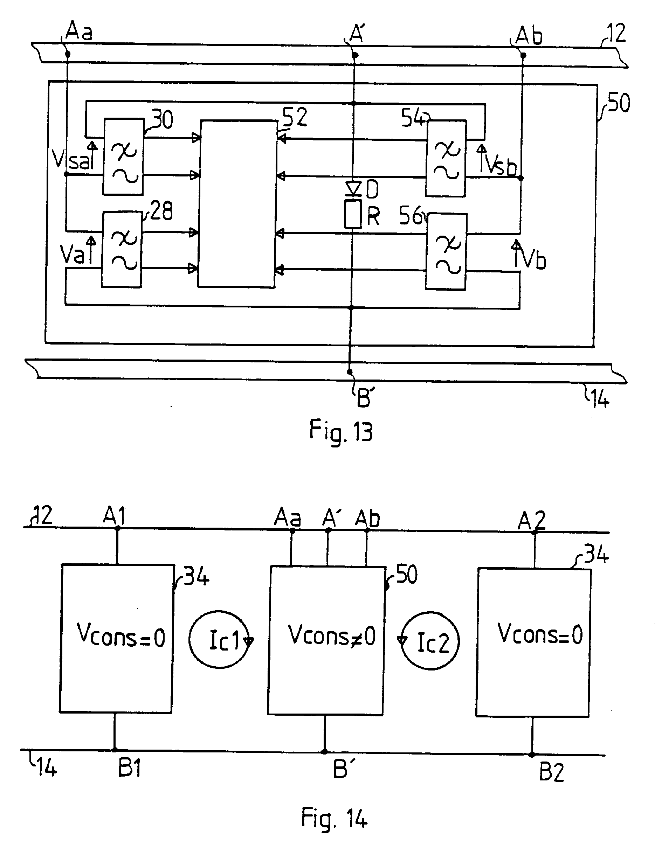

Le module de mesure double 50 selon la figure 13 permet de surveiller une ligne simultanément en amont et en aval du module. Ce module se distingue de celui représenté à la figure 6 par le fait qu'il mesure simultanément la tension aux bornes de deux résistances de shunt formées par des portions de ligne AaA' et A'Ab, disposées respectivement an amont et en aval d'un point A' du conducteur 12 de la ligne à surveiller. Les tensions Vsa aux bornes du shunt Aa A' et Va aux bornes des point Aa et B' (éventuellement entre Aa et Ba, Ba étant situé en regard de Aa sur le conducteur 14) sont filtrées respectivement par des filtres 30 et 28, et leurs composantes continues obtenues en sortie des filtres sont appliquées aux entrées d'un circuit de traitement 52. De même les tensions Vsb aux bornes du shunt A'Ab et Vb aux bornes des points Ab et B', sont filtrées par des filtres 54 et 56 et appliquées au circuit de traitement 52. Ce circuit traite en parallèle, de manière analogue au circuit 32 du module 18, les informations relatives aux portions de ligne situées respectivement en amont et en aval des points A' et B'.

L'utilisation d'un module 50 en combinaison avec deux modules d'asservissement 34 connectés respectivement en amont (A1 B1) et en aval (A2 B2) des points A' et B' sur une ligne longue est schématisée à la figure 14. Il est ainsi possible de surveiller simultanément les portions de réseau A1 Aa/B1B' (courant continu Ic1) et AbA2/B'B2 (courant continu Ic2). Les modules de mesure 50 et d'asservissement 34 représentés sur la figure 14 sont standardisés et utilisent le même type d'étage de puissance asservi, la tension de consigne étant nulle pour les modules d'asservissement et non nulle pour le module de mesure.

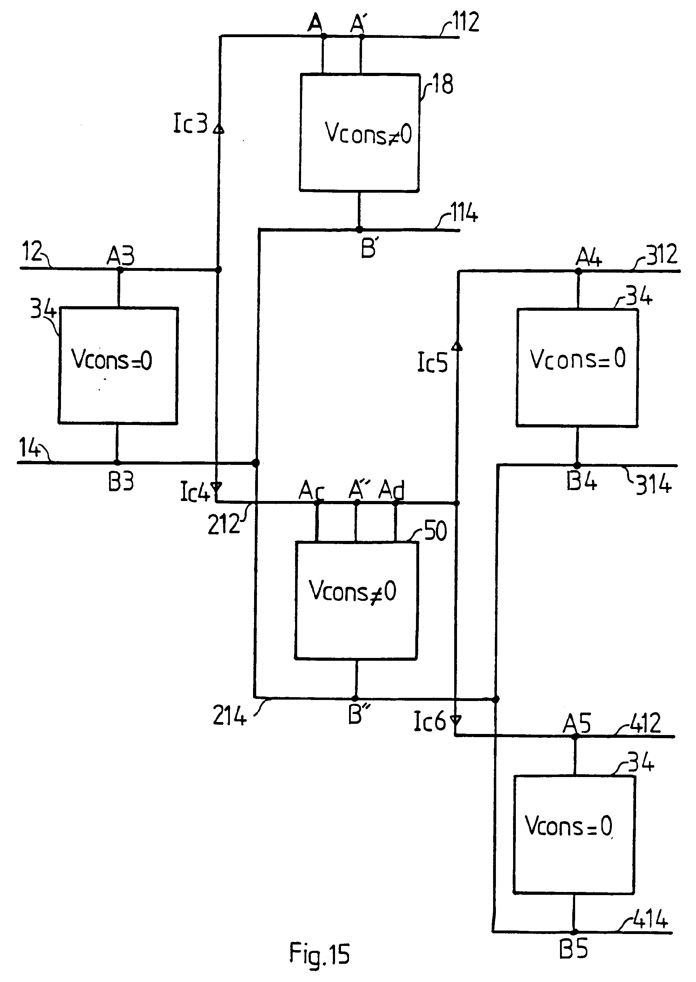

Le système décrit ci-dessus s'adapte à la surveillance de la conduction de réseaux de toute structure. A titre d'exemple, la figure 15 illustre un réseau de structure arborescente, tel qu'il se rencontre dans les tableaux basse tension et la disposition de modules permettant une surveillance de l'ensemble du réseau.

Sur la figure 15, les conducteurs (ou barres) 12 et 14 sont connectés à des conducteurs 112, 212 et, respectivement 114, 214, les conducteurs 212 et 214 étant connectés à des conducteurs 312, 412 et, respectivement 314, 414. Un premier module d'asservissement 34 est connecté entre des points A3 et B3 des conducteurs 12 et 14. Un module de mesure 18 est connecté à des points A et A' du conducteur 112 et B' du conducteur 114. Un module de mesure double 50 est connecté à des points Ac, A″ et Ad du conducteur 212 et B″ du conducteur 214. Un second module d'asservissement 34 est connecté à des points A4 et B4 des conducteurs 312 et 314, un troisième module d'asservissement étant connecté à des points A5 et B5 des conducteurs 412 et 414. Cet ensemble de modules permet donc de surveiller simultanément la conduction des portions de ligne A3A/B3B' (courant continu Ic3 dans le shunt AA'), A3Ac/B3B″ (courant continu Ic4 dans le shunt AcA″), AdA4/B″B4 et AdA5/B″B5 (courant continu Ic5 + Ic6 dans le shunt A″Ad).

Le système décrit ci-dessus est applicable non seulement à un réseau monophasé mais également à un réseau triphasé. Dans ce cas un premier module de mesure est disposé entre un premier et un second conducteurs de phase, un second module de mesure étant disposé entre les second et troisième conducteurs de phase, et éventuellement un troisième module de mesure entre le troisième conducteur de phase et un conducteur de neutre. Les trois modules de mesure peuvent éventuellement être regroupés dans un ensemble comportant un circuit unique de traitement. Les modules d'asservissement sont disposés de manière analogue et l'on peut ainsi surveiller la conduction de l'ensemble des conducteurs.

Comme indiqué ci-dessus, le système décrit à la figure 15 permet de surveiller les portions de ligne comprises entre un module d'asservissement (34) et un module de mesure simple (18) ou double (50). Une telle surveillance peut, dans certains cas être insuffisante. La figure 16 représente, de façon encore plus schématique, le réseau arborescent de la figure 15. Sur cette figure, les deux conducteurs d'une portion de ligne sont schématisés par un seul fil 13 pour les conducteurs 12 et 14, 113 pour les conducteurs 112 et 114, 213 pour les conducteurs 212 et 214, 313 pour les conducteurs 312 et 314 et 413 pour les conducteurs 412 et 414. Les modules d'asservissements 34 (Ma1, Ma2, Ma3) et de mesure simple 18 (Mm) ou double 50 (Mmd) sont schématisés aux mêmes emplacements que sur la figure 15. La figure 16 représente de plus les résistances de ligne des diverses portions de ligne: RLO1 pour la portion de la ligne principale 13 disposée en aval du premier module d'asservissement. RL11 pour la portion de la ligne terminale 113 disposée en amont du module de mesure simple (Mm), RL21 pour la portion de la ligne intermédiaire 213 disposée en amont du module de mesure double (Mmd), RL22 pour la portion de la ligne intermédiaire 213 disposée en aval du module de mesure double (Mmd), RL31 pour la portion de la ligne terminale 313 disposée en amont du module d'asservissement Ma2, et RL41 pour la portion de la ligne terminale 413 disposée en amont du module d'asservissement Ma3. La disposition représentée sur les figures 15 et 16 permet de surveiller séparément les résistances de ligne RLO1 + RL11, RL01 + RL21, RL22 + RL31 et RL22 + RL41. Cependant, la résistance RLO1 est généralement très inférieure aux résistances RL11 et RL21. De même, la résistance RL22 est très inférieure aux résistances RL31 et RL41. A titre d'exemple, la résistance RLO1 peut être de l'ordre de 100 microohms, tandis que les résistances RL31 et RL41 sont de l'ordre de la dizaine de milliohms. Avec la disposition décrite, une variation de RLO1 ou de RL22, très faible par rapport à la résistance de ligne surveillée (RL01 + RL11 ou RLO1 + RL21 par exemple), est très difficilement détectable.

Selon un développement de l'invention illustré aux figures 17 et 18, il est possible de surveiller séparément, avec la même précision, la résistance de ligne (RLO1, RL11, RL23 = RL 21 + RL22, RL31, RL41) de chaque portion de ligne d'un réseau arborescent avec un seul module d'asservissement Ma, disposé sur la ligne principale (13) à l'extrémité amont du réseau à surveiller et un module de mesure 58 (Mm1, Mm2, Mm3, Mmi) à l'extrémité aval de chaque ligne terminale (113,313,413) à surveiller. Les modules de mesures sont reliés, de préférence par l'intermédiaire d'un bus 60, à une unité centrale de traitement 62.

Le module d'asservissement (Ma) de la figure 17 est un module du type décrit précédemment. Par contre, les modules de mesure (Mm1,Mm2,Mm3,Mmi) sont modifiés de la manière décrite ci-dessous en regard de la figure 18.

Le module de mesure 58 selon la figure 18 comporte, comme le module illustré à la figure 6 des bornes 20 et 22 destinées à être reliées à des points A et B des conducteurs 12 et 14 du réseau. Les bornes 20 et 22 sont connectées aux entrées d'un filtre passe-bas 28 dont les signaux de sortie représentent la composante continue de la tension V.

Le module 58 comporte également un étage de puissance destiné à imposer une composante continue de courant entre les points A et B. Cet étage de puissance doit pouvoir être contrôlé, de manière à imposer le passage de cette composante continue uniquement pendant des périodes déterminées par l'unité centrale de traitement 62. L'étage de puissance peut être du type, thyristor et résistance R1, représenté à la figure 9. Dans le mode de réalisation préférentiel de la figure 18, l'étage de puissance est constitué par un triac Tr disposé en série avec une résistance L entre les bornes 20 et 22 du module. Un régulateur 64 commande la conduction du triac de manière à imposer une composante continue prédéterminée Ic ref. Le régulateur 64 reçoit un signal représentatif du courant Ic parcourant le triac, mesuré par exemple au moyen d'une résistance de shunt Rs1, de très faible valeur, en série avec l'étage de puissance. La résistance de shunt Rs1 étant très faible, par exemple de l'ordre de 0,1 ohm, elle ne supprime pas les avantages de l'étage de puissance non dissipatif.

La valeur Ic ref de la composante continue du courant étant constante, imposée par le régulateur, il n'est pas nécessaire d'appliquer au circuit de traitement des signaux représentatifs de cette composante continue. La variation de la composante continue de la tension V est alors représentative d'une variation de la résistance de ligne. En conséquence, le circuit de traitement 66 est connecté à la sortie du filtre 28. Le circuit de traitement 66 et le régulateur 64 sont connectés à l'unité centrale de traitement 62, de préférence par l'intermédiaire du bus 60 connecté à une borne de communication du module de mesure 58.

L'unité centrale de traitement 62 contrôle, par le bus 60 et les régulateurs 64 des modules de mesure Mmi, la mise en service séquentielle des étages de puissance des différents modules de mesure (Mm1,Mm2,Mm3m,fig.17), un seul étage de puissance étant actif à un instant donné. Les circuits de traitement 66 des différents modules Mmi surveillent en permanence la composante continue de la tension V correspondante et communiquent ces valeurs, ou leurs variations, à l'unité centrale de traitement. Celle-ci peut en déduire des grandeurs représentatives des valeurs individuelles des résistances de ligne de toutes les portions de ligne du réseau. Dans ce système, la surveillance de la variation des valeurs représentatives des résistances de ligne, leur comparaison à un seuil approprié et la signalisation d'un défaut sont réalisés au niveau de l'unité centrale de traitement, et non au niveau des circuits de traitement des modules de mesure.

Le tableau ci dessous indique les résistances de ligne correspondant aux mesures effectuées par les divers modules de mesure de la figure 17 en fonction des modules dont les étages de puissance sont activés:

| | | Module dont l'étage de puissance est activé | | |
|---|---|---|---|---|
| | | Mm1 | Mm2 | Mm3 |
| Module de mesure | Mm1 | RLO1 + RL11 | RLO1 | RLO1 |
| | Mm2 | RLO1 | RLO1+RL23+RL31 | RLO1+RL23 |
| | Mm3 | RLO1 | RLO1+RL23 | RLO1+RL23+RL41 |

Ainsi un défaut sur la ligne principale (13) est détecté à la fois par les modules Mm2 et Mm3 lorsque le module Mm1 est activé et par le module Mm1 lorsqu'un des autres modules est activé. La résistance RLO1 étant très inférieure à RL11, un défaut sur la ligne terminale 113 est détecté par le module Mm1 lorsqu'il est activé, tandis qu'un défaut sur l'une des lignes terminales 313 et 413 est détecté respectivement par les modules Mm2 et Mm3 lorsqu'ils sont activés. Les modules Mm2 et Mm3 détectent tous deux un défaut sur la ligne intermédiaire 213, respectivement lorsque les modules Mm3 et Mm2 sont activés.

Ces différentes mesures sont transmises à l'unité centrale de traitement 62 qui compare leurs variations à des seuils appropriés, de manière à obtenir la même sensibilité pour tous les défauts, et à détecter et localiser rapidement un défaut sur l'une quelconque des portions du réseau.

Il ressort du tableau ci-dessus, qu'un défaut sur la ligne principale est détecté quelque soit le module de mesure activé, tandis qu'un défaut sur une ligne terminale n'est détecté que lorsque le module de mesure associé à cette ligne est activé. Ainsi, la fréquence des mesures est proportionnelle à l'importance de la ligne.

Une séquence de mesure comporte de préférence également une phase de mesure pendant laquelle aucun module de mesure n'étant activé, les tensions d'offset des différents modules sont mesurées.

## Revendications

1. Système de mesure de la résistance de la ligne (RL) d'un réseau comportant des premier et second conducteurs (12,14) alimentés par une source de tension alternative (10), comportant au moins un module de mesure (18,50) comportant des moyens (D,R;Th1,R1;D1-D4,T1,R1;Tr,L) de production d'une composante continue de courant (Ic) entre des premier et second points (A; B, B') situés respectivement sur les premier et second conducteurs, des moyens de mesure de la tension (V) appliquée entre ces premier et second points (A,B) et des moyens (28) d'extraction de la composante continue (Vc) de ladite tension, système caractérisé en ce qu'il est destiné à assurer un contrôle permanent de la conduction électrique d'au moins une portion du réseau, la sortie des moyens d'extraction étant connectée à l'entrée d'un circuit de traitement et de signalisation (32;52;66,62) comportant des moyens (F4) de calcul d'une valeur représentative de la résistance de ligne (RL) d'une portion du réseau, des moyens (F7) de détection d'une variation (DRL) de ladite valeur, des moyens (F8) de comparaison de ladite variation (DRL) à un seuil prédéterminé (S1) et des moyens de signalisation d'un défaut de conduction lorsque ladite variation dépasse ledit seuil.

9

2. Système selon la revendication 1, caractérisé en ce que le module de mesure (18) comporte une résistance de mesure (R) parcourue par ladite composante continue de courant (Ic), des moyens de mesure de la tension (Vr) aux bornes de la résistance de mesure et des moyens d'extraction de la composante continue de ladite tension, la valeur représentative de la résistance de ligne (RL) calculée par le circuit de traitement étant proportionnelle au rapport des composantes continues des tensions (V,Vr) mesurées respectivement entre lesdits premier et second points (A,B) et aux bornes de la résistance de mesure (R).

3. Système selon la revendication 1, caractérisé en ce que les moyens de production de la composante continue de courant sont destinés à être connectés entre ledit second point (B) et un troisième point (A′) du premier conducteur (12) adjacent au premier point (A, Aa, Ab) de manière à délimiter entre les premier et troisième points une résistance de shunt (Rs) constituée par une portion sans contact (AA′, Aa A′, A′ Ab) du premier conducteur, le module de mesure (18,50) comportant des moyens de mesure de la tension (Vs, Vsa, Vsb) aux bornes de la résistance de shunt (Rs) et des moyens (30,54) d'extraction de la composante continue ((Vs)c) de la tension aux bornes de la résistance de shunt, la valeur représentative de la résistance de ligne (RL) calculée par le circuit de traitement (32,52) étant proportionnelle au rapport des composantes continues (Vc et (Vs)c) des tensions (V,Vs) mesurées respectivement entre lesdits premier et second points (A,B) et aux bornes de la résistance de shunt (Rs).

4. Système selon l'une quelconque des revendications précédentes, caractérisé en ce qu'il comporte au moins un module de rebouclage (34) comportant des bornes d'entrée (36,38) destinées à être connectées à des quatrième (A1, A3) et cinquième (B1, B3) points situés respectivement sur les premier et second conducteurs (12,14) du réseau, ledit module de rebouclage comportant des moyens de bouclage de ladite composante continue de courant (Ic), la résistance de ligne (RL) calculée par le circuit de traitement du module de mesure étant la résistance de ligne de la portion de réseau (AB-A1B1) comprise entre les modules de mesure et de rebouclage.

5. Système selon la revendication 4, caractérisé en ce que le module de rebouclage est un module d'asservissement comportant des moyens d'asservissement à zéro de la composante continue (V1c) de la tension (V1) appliquée entre ses bornes d'entrée (36,38).

6. Système selon la revendication 1, caractérisé en ce qu'il comporte un module de mesure double (50) destiné à être connecté audit point (B′) et à des sixième, septième, et huitième points (Aa, A′, Ab) du premier conducteur 12 délimitant entre eux deux résistances de shunt constituées par deux portions (AaA′, A′Ab) adjacentes sans contact du premier conducteur, les moyens de production de la composante continue du courant du module de mesure double (50) étant destinés à être connectés entre lesdits second et septième points (A′,B′), le module de mesure double (50) comportant des moyens de mesure des tensions (Vsa,Vsb) aux bornes des deux résistances de shunt, des moyens de mesure des tensions (Va, Vb) appliquées entre le second (B′) et, respectivement, le sixième (Aa) ou le huitième (Ab) points et des moyens (28,30;54,56) d'extraction des composantes continues desdites tensions, le système comportant un premier module d'asservissement (34) destiné à être connecté à des quatrième (A1, A3) et cinquième (B1, B3) points situés respectivement sur les premier et second conducteurs (12, 14) en amont du module de mesure double (50) et un second module d'asservissement (34) destiné à être connecté à des neuvième (A2, A4, A5) et dixième (B2, B4, B5) points situés respectivement sur les premier et second conducteurs (12, 14) en aval du module de mesure double (50), chaque module d'asservissement (34) comportant des moyens (R1; Th1 ; T1, D1-D4; Tr, L) de bouclage de la composante continue de courant et des moyens d'asservissement à zéro de la composante continue de la tension appliquée entre ses bornes d'entrée, le circuit de traitement (52) du module de mesure double (50) calculant les valeurs représentatives des résistances de ligne des deux portions de réseau comprises entre le module de mesure double et les deux modules d'asservissement associés.

7. Système selon l'une des revendications 5 et 6 caractérisé en ce que le module d'asservissement (34) comporte un filtre passe-bas (40) dont les entrées sont connectées aux bornes d'entrée (36,38) du module d'asservissement, la sortie du filtre étant connectée à une première entrée d'un régulateur (42) dont une seconde entrée reçoit une valeur de consigne nulle (Vcons = 0), la sortie (S1) du régulateur (42) étant appliquée à l'entrée d'un circuit de commande (44) dont la sortie (S2) est connectée à une électrode de commande d'un redresseur contrôlé (Th1;T1,D1-D4;Tr,L) connecté entre les bornes d'entrée du module d'asservissement et assurant le bouclage de la composante continue de courant (Is).

8. Système selon l'une quelconque des revendications 1 à 7, caractérisé en ce que les moyens de production d'une composante continue du courant (Ic) d'un module de mesure (18,50,58) comportent un redresseur contrôlé (Th1;T1,D1D4;Tr1), dont la commande est connectée à la sortie d'un régulateur (42,64).

9. Système selon la revendication 8, caractérisé en ce qu'il comporte une unité centrale de traitement (62) connectée à chaque module de mesure (58) de manière à commander la mise en service du redresseur contrôlé du module de mesure.

10. Système selon la revendication 9, destiné à la surveillance d'un réseau comportant une pluralité de branches, caractérisé en ce qu'il comporte un module d'asservissement (Ma) disposé en amont de la portion du réseau à surveiller et un module de mesure (Mm1,Mm2,Mm3) connecté en aval de chacune des branches terminales du réseau à surveiller, l'unité centrale de traitement (62) commandant la mise en service séquentielle des redresseurs contrôlés (Tr) des modules de mesure, un seul redresseur contrôlé étant actif à un instant donné, l'unité centrale de traitement recevant en permanence des différents modules de mesure une valeur représentative de la composante continue de la tension aux bornes dudit module de mesure, l'unité centrale de traitement (62) comportant des moyens de calcul des valeurs représentatives de la résistance de ligne des diverses portions du réseau, des moyens de détection d'une variation desdites valeurs, des moyens de comparaison desdites variations à des seuils respectifs prédéterminés, et des moyens de signalisation d'un défaut de conduction dans l'une desdites portions lorsque la variation de la valeur associée à ladite portion dépasse le seuil correspondant.


## Patentansprüche

1. System zur Messung des Leitungswiderstands (RL) in einem Leitungsnetz mit über eine Wechselspannungsquelle (10) gespeisten ersten und zweiten Netzleitern (12, 14), welches mindestens ein Meßmodul (18, 50) mit Mitteln (D, R; Th1, R1; D1-D4; T1, R1, Tr, L) zur Erzeugung eines zwischen auf dem ersten bzw. zweiten Netzleiter angeordneten ersten und zweiten Punkten (A; B, B') fließenden Gleichstromanteils (Ic), Mittel zur Messung der an diesen ersten und zweiten Punkt (A, B) angelegten Spannung (V) sowie Mittel (28) zur Rückgewinnung des Gleichanteils (Vc) der genannten Spannung umfaßt, dadurch gekennzeichnet, daß es dazu dient, eine kontinuierliche Überwachung der elektrischen Leitung in mindestens einem Leitungsabschnitt zu gewährleisten, wobei die Ausgänge der Mittel zur Rückgewinnung des Gleichanteils an den Eingang einer Verarbeitungs- und Anzeigeschaltung (32; 52; 66, 62) angeschlossen sind, welche Mittel (F4) zur Berechnung eines den Leitungswiderstand (RL) in einem Netzabschnitt abbildenden Werts, Mittel (F7) zur Erfassung einer Änderung (DRL) des genannten Werts, Mittel (F8) zum Vergleich der genannten Änderung (DRL) mit einem festgelegten Grenzwert (S1) sowie Mittel zur Anzeige eines Leitungsfehlers bei Überschreiten des genannten Grenzwerts durch die genannte Änderung aufweist.

2. System nach Anspruch 1, dadurch gekennzeichnet, daß das Meßmodul (18) einen vom genannten Gleichstromanteil (Ic) durchflossenen Meßwiderstand (R), Mittel zur Messung der an den Klemmen des Meßwiderstands anliegenden Spannung (Vr) sowie Mittel zur Rückgewinnung des Gleichanteils der genannten Spannung umfaßt, wobei der den Leitungswiderstand (RL) abbildende, durch die Verarbeitungsschaltung errechnete Wert dem Verhältnis aus den Gleichanteilen der zwischen dem genannten ersten und zweiten Punkt (A,B) bzw. an den Klemmen des Meßwiderstands (R) gemessenen Spannungen (V, Vr) proportional ist.

3. System nach Anspruch 1, dadurch gekennzeichnet, daß die Mittel zur Erzeugung des Gleichstromanteils dazu bestimmt sind, zwischen dem genannten zweiten Punkt (B) und einem auf dem ersten Netzleiter (12) in der Nähe des ersten Punkts (A, Aa, Ab) angeordneten dritten Punkt (A') angeschlossen zu werden, um so einen zwischen dem ersten und dem dritten Punkt liegenden Reihenwiderstand (Rs) zu bestimmen, der aus einem kontaktfreien Abschnitt (AA', Aa A', A'Ab) des ersten Netzleiters besteht, wobei das Meßmodul (18, 50) Mittel zur Messung der an den Klemmen des Reihenwiderstands (Rs) anliegenden Spannung (Vs, Vsa, Vsb) sowie Mittel (30, 54) zur Rückgewinnung des Gleichanteils ((Vs)c) der an den Klemmen des Reihenwiderstands anliegenden Spannung umfaßt und der den Leitungswiderstand (RL) abbildende durch die Verarbeitungsschaltung (32, 52) errechnete Wert dem Verhältnis aus den Gleichanteilen (Vc und (Vs)c) der zwischen dem genannten ersten und zweiten Punkt (A, B) bzw. den Klemmen des Reihenwiderstands (Rs) gemessenen Spannungen (V, Vs) proportional ist.

**4.** System nach irgendeinem der vorhergehenden Ansprüche, dadurch gekennzeichnet, daß es mindestens ein Rückführmodul (34) umfaßt, dessen Eingangsklemmen (36, 38) dazu dienen, an einen auf dem ersten bzw. zweiten Netzleiter (12, 14) angeordneten vierten bzw. fünften Punkt (A1, A3; B1, B3) angeschlossen zu werden, und daß das genannte Rückführmodul Mittel zur Rückführung des genannten Gleichstromanteils (Ic) aufweist, wobei der durch die Verarbeitungsschaltung des Meßmoduls errechnete Leitungswiderstand (RL) gleich dem Leitungswiderstand des zwischen Meß- und Rückführmodul liegenden Netzabschnitts (AB-A1B1) ist.

**5.** System nach Anspruch 4, dadurch gekennzeichnet, daß das Rückführmodul als ein Regelmodul ausgeführt ist, das Mittel zur Nullausregelung des Gleichanteils (V1c) der an seinen Eingangsklemmen (36, 38) angelegten Spannung (V1) aufweist.

**6.** System nach Anspruch 1, dadurch gekennzeichnet, daß es ein Doppel-Meßmodul (50) aufweist, das dazu dient, zwischen den genannten Punkt (B′) sowie einen sechsten, siebten und achten Punkt (Aa, A′, Ab) des ersten Netzleiters (12) angeschlossen zu werden, so daß zwischen den Endpunkten zwei als kontaktfreie aneinandergrenzende Abschnitte (AaA′, A′Ab) des ersten Netzleiters ausgebildete Reihenwiderstände entstehen, wobei die Mittel zur Erzeugung des Gleichstromanteils des Doppel-Meßmoduls (50) dazu dienen, zwischen den genannten zweiten und den genannten siebten Punkt (A′, B′) angeschlossen zu werden, das Doppel-Meßmodul (50) Mittel zur Messung der an den Klemmen der beiden Reihenwiderstände anliegenden Spannungen (Vsa, Vsb), Mittel zur Messung der zwischen dem zweiten Punkt (B′) und dem sechsten Punkt (Aa) bzw. achten Punkt (Ab) angelegten Spannungen (Va, Vb) sowie Mittel (28, 30; 54, 56) zur Rückgewinnung der Gleichanteile der genannten Spannungen umfaßt, das System ein erstes Regelmodul (34) zum Anschluß an einen auf dem ersten bzw. zweiten Netzleiter (12, 14) auf der Einspeiseseite des Doppel-Meßmoduls (50) angeordneten vierten Punkt (A1, A3) und fünften Punkt (B1, B3) sowie ein zweites Regelmodul (34) zum Anschluß an einen auf dem ersten bzw. zweiten Netzleiter (12, 14) auf der Abgangsseite des Doppel-Meßmoduls (50) angeordneten neunten Punkt (A2, A4, A5) und zehnten Punkt (B2, B4, B5) aufweist, jedes Regelmodul (34) Mittel (R1; Th1; T1, D1-D4; Tr, L) zur Rückführung des Gleichstromanteils sowie Mittel zur Nullausregelung des Gleichanteils der an seine Eingangsklemmen angelegten Spannung umfaßt und die Verarbeitungsschaltung (52) des Doppel-Meßmoduls (50) die Werte errechnet, die die Leitungswiderstände der beiden zwischen dem Doppel-Meßmodul und den beiden Regelmodulen liegenden Netzabschnitte abbilden.

**7.** System nach Anspruch 5 oder 6, dadurch gekennzeichnet, daß das Regelmodul (34) ein Tiefpaßfilter (40) umfaßt, dessen Eingänge an die Eingangsklemmen (36, 38) des Regelmoduls angeschlossen sind, wobei der Ausgang des Filters mit einem ersten Eingang eines Reglers (42) verbunden ist, dessen zweiter Eingang mit einem Null-Sollwert (Vcons = 0) beaufschlagt wird, und das Ausgangssignal (S1) des Reglers (42) dem Eingang einer Ansteuerschaltung (44) zugeführt wird, mit deren Ausgangssignal (S2) eine Steuerelektrode eines gesteuerten Gleichrichters (Th1; T1, D1-D4, Tr, L) beaufschlagt wird, der mit den Eingangsklemmen des Regelmoduls verbunden ist und die Rückführung des Gleichstromanteils (Ic) gewährleistet.

**8.** System nach irgendeinem der Ansprüche 1 bis 7, dadurch gekennzeichnet, daß die Mittel zur Erzeugung eines Gleichstromanteils (Ic) eines Meßmoduls (18, 50, 58) einen gesteuerten Gleichrichter (Th1; T1, D1-D4; Tr1) umfassen, dessen Steuereingang an den Ausgang eines Reglers (42, 64) angeschlossen ist.

**9.** System nach Anspruch 8, dadurch gekennzeichnet, daß es eine Zentraleinheit (62) umfaßt, die mit jedem Meßmodul (58) verbunden ist, um die Aktivierung des gesteuerten Gleichrichters des Meßmoduls zu steuern.

**10.** System nach Anspruch 9 zur Überwachung eines Leitungsnetzes mit mehreren Abzweigen, dadurch gekennzeichnet, daß es ein auf der Einspeiseseite des zu überwachenden Netzabschnitts angeordnetes Regelmodul (Ma) und ein auf der Abgangsseite jeder Endverzweigung des zu überwachenden Netzes angeordnetes Meßmodul (Mm1, Mm2, Mm3) aufweist, wobei die Zentraleinheit (62) nacheinander die gesteuerten Gleichrichter (Tr) der Meßmodule ansteuert, zu einem gegebenen Zeitpunkt nur jeweils ein gesteuerter Gleichrichter aktiv ist, die Zentraleinheit von den verschiedenen Meßmodulen ununterbrochen einen den Gleichanteil der Spannung an den Klemmen des genannten Meßmoduls abbildenden Wert empfängt, die Zentraleinheit (62) Mittel zur Berechnung der die Leitungswiderstände der einzelnen Netzabschnitte abbildenden Werte, Mittel zur Erfassung einer Änderung der genannten Werte, Mittel zum Vergleich der genannten Änderungen mit zugeordneten festgelegten Grenzwerten sowie Mittel zur Anzeige eines Leitungsfehlers in einem der genannten Netzabschnitte bei Überschreiten des jeweiligen Grenzwerts durch die dem genannten Netzabschnitt zugeordnete Änderung umfaßt.

**Claims**

1. A system for measuring the line resistance (RL) of a power supply system comprising first and second conductors (12, 14) supplied by an AC voltage source (10), comprising at least one measuring module (18, 50) comprising means (D,R; R1; D1-D4, T1, R1; Tr, L) for producing a DC current component (Ic) between first and second points (A; B, B') located respectively on the first and second conductors, means for measuring the voltage (V) applied between these first and second points (A, B), and means (28) for extracting the DC component (Vc) of said voltage, a system characterized in that it is designed to perform continuous monitoring of the electrical conduction of at least a portion of the power supply system, the output of the means for extracting being connected to the input of a processing and signalling circuit (32; 52; 66,62) comprising means (F4) for computing a value representative of the line resistance (RL) of a portion of the power supply system, means (F7) for detecting a variation (DRL) of said value, means (F8) for comparing said variation (DRL) with a preset threshold (S1) and means for signalling a conduction fault when said variation exceeds said threshold.

2. The system according to claim 1, characterized in that the measuring module (18) comprises a measuring resistance (R) having said DC current component (Ic) flowing through it, means for measuring the voltage (Vr) at the terminals of the measuring resistance and means for extracting the DC component of said voltage, the value representative of the line resistance (RL) computed by the processing circuit being proportional to the ratio of the DC components of the voltages (V, Vr) measured respectively between said first and second points (A, B) and at the terminals of the measuring resistance (R).

3. The system according to claim 1, characterized in that the means for producing the DC current component are designed to be connected between said second point (B) and a third point (A') of the first conductor (12) adjacent to the first point (A, Aa, Ab) so as to bound between the first and third points a shunt resistance (Rs) formed by a contact-free portion (AA', Aa A', A'Ab) of the first conductor, the measuring module (18, 50) comprising means for measuring the voltage (Vs, Vsa, Vsb) at the terminals of the shunt resistance (Rs) and means (30, 54) for extracting the DC component ((Vs)c) of the voltage at the terminals of the shunt resistance, the value representative of the line resistance (RL) computed by the processing circuit (32, 52) being proportional to the ratio of the DC components (Vc and (Vs)c) of the voltages (V, Vs) measured respectively between said first and second points (A, B) and at the terminals of the shunt resistance (Rs).

4. The system according to any one of the foregoing claims, characterized in that it comprises at least one looping module (34) comprising input terminals (36, 38) designed to be connected to fourth (A1, A3) and fifth (B1, B3) points located respectively on the first and second conductors (12, 14) of the power supply system, said looping module comprising means for looping said DC current component (Ic), the line resistance (RL) computed by the processing circuit of the measuring module being the line resistance of the portion of power supply system (AB-A1B1) comprised between the measuring and regulating modules.

5. The system according to claim 4, characterized in that the looping module is a regulating module comprising means for regulating the DC component (V1c) of the voltage (V1) applied between its input terminals (36, 38) to zero.

6. The system according to claim 1, characterized in that it comprises a double measuring module (50) designed to be connected to said point (B') and to sixth, seventh, and eighth points (Aa, A', Ab) of the first conductor (12) bounding between them two shunt resistances formed by two adjacent contact-free portions (AaA', A'Ab) of the first conductor, the means for producing the DC current component of the double measuring module (50) being designed to be connected between said second and seventh points (A', B'), the double measuring module (50) comprising means for measuring the voltages (Vsa, Vsb) at the terminals of the two shunt resistances, means for measuring the voltages (Va, Vb) applied between the second (B') and, respectively, the sixth (Aa) or eighth (Ab) points and means (28, 30; 54, 56) for extracting the DC components of said voltages, the system comprising a first regulating module (34) designed to be connected to fourth (A1, A3) and fifth (B1, B3) points located respectively on the first and second conductors (12, 14) upstream from the double measuring module (50) and a second regulating module (34) designed to be connected to ninth (A2, A4, A5) and tenth (B2, B4, B5) points located respectively on the first and second conductors (12, 14) downstream from the double measuring module (50), each regulating module (34) comprising means (R1; Th1; T1, D1-D4; Tr, L) for looping the DC current component and means for regulating the DC component of the voltage applied between its input terminals to zero, the processing circuit (52) of the double measuring module (50) computing the values representative of the line resistances of the two portions of power supply system comprised between the double measuring module and the two associated regulating modules.

7. The system according to one of the claims 5 and 6, characterized in that the regulating module (34) comprises a low-pass filter (40) whose inputs are connected to the input terminals (36, 38) of the regulating module, the filter output being connected to a first input of a controller (42) a second input of which receives a zero setpoint value (Vcons = 0), the output (S1) of the controller (42) being applied to the input of a control circuit (44) whose output (S2) is connected to a control electrode of a controlled rectifier (Th1; T1, D1-D4; Tr, L) connected between the input terminals of the regulating module and performing looping of the DC current component (Is).

8. The system according to any one of the claims 1 to 7, characterized in that the means for producing a DC current component (Ic) of a measuring module (18, 50, 58) comprise a controlled rectifier (Th1; T1, D1D4; Tr1) whose control is connected to the output of a controller (42, 64).

9. The system according to claim 8, characterized in that it comprises a central processing unit (62) connected to each measuring module (58) so as to command activation of the controlled rectifier of the measuring module.

10. The system according to claim 9, designed for monitoring a power supply system comprising a plurality of branches, characterized in that it comprises a regulating module (Ma) located upstream from the portion of the power supply system to be monitored and a measuring module (Mm1, Mm2, Mm3) connected downstream from each of the terminal branches of the power supply system to be monitored, the central processing unit (62) commanding sequential activation of the controlled rectifiers (Tr) of the measuring modules, a single controlled rectifier being active at a given time, the central processing unit continuously receiving from the different measuring modules a value representative of the DC component of the voltage at the terminals of said measuring module, the central processing unit (62) comprising means for computing the values representative of the line resistance of the different portions of the power supply system, means for detecting a variation of said values, means for comparing said variations with preset respective thresholds, and means for signalling a conduction fault in one of said portions when the variation of the value associated with said portion exceeds the corresponding threshold.

Fig.1

Fig.2

Fig.3

Fig.4

Fig.5

Fig. 6

Fig. 8

Fig.7

Fig.9

Fig.10

Fig.11

Fig.12

Fig. 13

Fig. 14

Fig.15

Fig. 16

Fig. 17

Fig. 18